# EUROPÄISCHE PATENTSCHRIFT

(11) **EP 3 120 676 B1**
(45) Veröffentlichungstag und Bekanntmachung des Hinweises auf die Patenterteilung: **14.03.2018**
(21) Anmeldenummer: 15700879.8
(22) Anmeldetag: 22.01.2015
(51) Int. Cl.: H05K 5/00

(54) **ELEKTRONISCHES STEUERMODUL UND VERFAHREN ZU SEINER HERSTELLUNG**
ELECTRONIC CONTROL MODULE AND METHOD FOR PRODUCING THE SAME
MODULE DE COMMANDE ÉLECTRONIQUE ET PROCÉDÉ SERVANT À FABRIQUER LEDIT MODULE

(30) Priorität: 19.03.2014 DE 102014205139
(43) Veröffentlichungstag der Anmeldung: 25.01.2017
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2015/051194
(87) Internationale Veröffentlichungsnummer: WO 2015/139861

(56) Entgegenhaltungen:
- WO-A1-2008/022822
- DE-A1-102004 061 818
- DE-A1-102005 015 717
- DE-A1-102006 050 351
- DE-A1-102010 062 653
- DE-A1-102012 207 057

## Beschreibung

### Stand der Technik

In der Kraftfahrzeugtechnik werden zur Getriebeansteuerung elektronische Steuermodule verwandt, die am Getriebe und im Getriebefluid angeordnet werden können. Die Steuermodule können beispielsweise elektrische Bauelemente wie Stecker, Sensoren, Aktuatoren, wenigsten ein gekapseltes Steuergerät (TCU, Transmission Control Unit) und gegebenenfalls weitere Komponenten aufweisen, die an einem zentralen Träger befestigt sind und dem Getriebefluid ausgesetzt sind. Die Anordnung im Getriebefluid stellt hohe Herausforderungen an die Aufbau- und Verbindungstechnik der Baukomponenten auf dem Träger des elektronischen Steuermoduls, da die elektrischen Verbindungen hohen Temperaturwechselbelastungen sowie dem Getriebefluid wiederstehen können müssen. Als Träger der elektrischen Verbindungstechnik werden im Stand der Technik umspritzte Stanzgitter sowie starre Leiterplatten oder flexible Leiterplatten (sogenannte Flexfolien) eingesetzt. Besondere Herausforderungen für die Anwendung im Getriebe bestehen in der dichten Anordnung eines Deckelteils über dem elektronischen Schaltungsteils des Steuermoduls.

Unabhängig von der Anwendung im Getriebe sind elektronische Steuermodule bekannt, die eine flexible Leiterplatte aufweisen, die auf eine Trägerplatte laminiert ist, wobei in einer Aussparung der flexiblen Leiterplatte ein elektronisches Schaltungsteil auf die Trägerplatte aufgeklebt und über Bonddrähte mit der flexiblen Leiterplatte kontaktiert ist. Ein das elektronische Schaltungsteil bergendes Deckelteil ist unter Zwischenlage eines umlaufenden Dichtelements auf die flexible Leiterplatte aufgebracht. Solche Steuermodule sind beispielsweise aus der DE 10 2005 015 717 A1 bekannt. Für den Einsatz im Getriebe besteht hier eine besondere Schwierigkeit darin, die Dichtung zwischen Deckelteil und flexibler Leiterplatte hermetisch abzudichten, da sonst Getriebefluid in den Gehäuseinnenraum eindringt. Ein einfacher umlaufender Dichtring, wie ihn die DE 10 2005 015 717 A1 offenbart, weist hier Nachteile auf, denn Dichtringe benötigen geometrischen Freiraum, was bei Temperaturänderungen zu Roll- und Gleitbewegungen und damit zu Schleppverlusten führt und im ungünstigen Fall Öl in den Gehäuseinnenraum befördern könnte.

Andere elektronische Steuermodule verwenden ein Deckelteil, das über dem elektronischen Schaltungsteil auf die Leiterplatte direkt aufgeklebt wird. So offenbart beispielsweise die DE 10 2012 200 914 A1 ein elektronisches Steuermodul, bei dem ein Deckelteil mit einem umlaufenden Kragen versehen ist, der direkt auf eine starre Leiterplatte aufgeklebt wird. Über in dem Kragen ausgebildet Öffnungen, in welche der Kleber eindringt, soll eine besonders gute Haftung erreicht werden.

Aus der DE 10 2011 085 054 A1 ist ein elektronisches Steuermodul bekannt, bei dem ein ummanteltes, rahmenartiges Stanzgitterteil auf eine Leiterplatte aufgeklebt wird. Die Leiterplatte ist auf eine Trägerplatte aufgebracht. Ein Schaltungsteil befindet sich in einer Aussparung der Leiterplatte auf der Trägerplatte. Als Kleber zum Aufkleben des ummantelten Stanzgitterteils wird ein Epoxidharzkleber oder ein Silikonkleber verwandt. Das aufwändig ausgestaltete, ummantelte Stanzgitterteil weist erste und zweite Schenkel auf, die zur Positionierung eines Deckelteils dienen, das mit dem ummantelten Stanzgitterteil verschweißt wird.

Trotz aller Verbesserungen und Weiterentwicklungen von Elektronikmodulen, welche Deckelteile verwenden, die direkt über einen Kleber auf eine Leiterplatte aufkleben werden, bestehen weiterhin besondere Herausforderungen in der Erzielung einer hermetisch dichten Abdichtung zwischen Deckelteil und Leiterplatte. Eine besondere Schwierigkeit besteht darin, dass beim Aufkleben des Deckelteils auf die Leiterplatte oft Wärme zugeführt wird, um den Kleber auszuhärten. Als Folge dehnt sich die Luft im Gehäuseinnenraum aus und dringt durch die auszuhärtende Kleberschicht hindurch nach außen. Aus diesem Grund muss oft eine Entlüftungsöffnung in dem Gehäuse vorgesehen werden, die dann wieder aufwändig abgedichtet werden muss. Schwierigkeiten bestehen weiterhin auch in der Auftragung der umlaufenden Kleberraupe. Wird diese sehr breit aufgetragen, so können sich oft Lufteinschlüsse in der Kleberraupe befinden, welche im Betrieb die Dichtheit beinträchtigen. Ist die Kleberaupe dagegen zu schmal, so kann oft von vornherein keine ausreichende Dichtheit erzielt werden.

### Offenbarung der Erfindung

Erfindungsgemäß wird ein elektronisches Steuermodul vorgeschlagen, das als Rahmenteil ein flaches, plattenförmiges, laminierbares Teil verwendet, das eine erste Fläche und eine dazu im Abstand von höchstens drei Millimetern angeordnete, zu der ersten Fläche planparallele zweite Fläche aufweist, wobei die erste Fläche des Rahmenteils mittels einer umlaufend aufgebrachten Klebefolie auf die Leiterplatte laminiert ist. Das Deckelteil weist einen umlaufenden Kragen auf, der flach auf die zweite Fläche des Rahmenteils aufgelegt und mittels eines Schweißvorgangs umlaufend mit dem Rahmenteil verschweißt ist.

### Vorteile der Erfindung

Die Erfindung löst die aus dem Stand der Technik bekannten Probleme durch die Verwendung eines laminierbaren Rahmenteils. Das erfindungsgemäß sehr flach ausgebildete Rahmenteil mit der äußeren Kontur einer planparallelen Platte ermöglicht es vorteilhaft, das Rahmenteil in einer Laminierpresse mit der Leiterplatte zu verkleben. Dieser Schritt kann vor der Auftragung des Schaltungsteils vorgenommen werden. Das Rahmenteil ist durch seine flache und planparallele Ausgestaltung besonders robust und kann daher problemlos hohen Druck- und Temperaturbelastungen ausgesetzt werden. Außerdem kann ein solches Rahmenteil einfach und preiswert hergestellt werden. Vorteilhaft kann ein Laminierkleber, der als dünne Klebefolie aus reinem Klebstoff von einer Trägerfolie abgezogen wird, auf die Leiterplatte oder auf das Rahmenteil flächig aufgelegt oder aufgerollt werden. In einer Laminierpresse kann dann der Stapel aus Leiterplatte und Rahmenteil und einer gegebenenfalls zusätzlich vorgesehen Trägerplatte, auf welche die Leiterplatte aufgebracht ist, unter Zufuhr von Druck und Temperatur laminiert werden. Auf diese Weise entsteht vorteilhaft eine flache, breite und doch blasenfreie Klebeverbindung zwischen dem Rahmenteil und der Leiterplatte. Diese spezielle Klebeverbindung ist hermetisch dicht. Nach Herstellung dieses Stapels wird das Schaltungsteil mit der Leiterplatte verbunden und das Deckelteil aufgesetzt. Das Deckelteil ist vorteilhaft mit einem umlaufenden Kragen versehen, der in einfacher Weise auf die von der Leiterplatte abgewandte Seite des Rahmenteils geschweißt werden kann, um einen vollständig geschlossenen, hermetisch gekapselten Gehäuseinnenraum zu bilden. Die Aufbringung des Deckelteils auf das flache Rahmenteil anstatt direkt auf die Leiterplatte erzeugt dabei keinen zusätzlichen Aufwand und ist einfach und kostengünstig durchführbar.

Weiterbildungen der Erfindung und vorteilhafte Ausführungsformen werden durch die in den abhängigen Ansprüchen angegebenen Merkmale ermöglicht.

Besonders bevorzugt ist, das Rahmenteil derart ausgebildet, dass die erste Fläche planparallel in einem Abstand von höchstens zwei Millimetern zu der zweiten Fläche angeordnet ist. Das auf die Leiterplatte aufgeklebte Rahmenteil wirkt dann quasi wie eine dünne, auf die Leiterplatte aufgebracht Schicht, auf welche geschweißt werden kann.

Vorteilhaft weist der Kragen eine erste Kragenfläche und eine dazu in einem Abstand angeordnete, zu der ersten Kragenfläche planparallele zweite Kragenfläche auf, so dass der Kragen in einfacher Weise von einer der Leiterplatte zugewandten Seite aus mit dem Rahmenteil verschweißt werden kann.

Das Rahmenteil und das Deckelteil können vorteilhaft aus Kunststoff bestehen. Der Schweißvorgang kann dann mittels eines Lasers durchgeführt werden. Besonders vorteilhaft kann das sogenannte Laserdurchlichtschweißen eingesetzt werden, bei dem ein Laserstrahl mit einer Wellenlänge, die für das Kunststoffmaterial des Kragens lichtdurchlässig ist, durch den Kragen hindurch die zweite Fläche des Rahmenteils aufschmilzt und derart das Deckelteil mit dem Rahmenteil verschweißt.

Das Rahmenteil und das Deckelteil können aber auch aus Metall bestehen und als Schweißverfahren kann beispielswiese ein Kondensator-Entladungsschweißen eingesetzt werden.

Besonders vorteilhaft ist eine Ausführung der Erfindung, bei der eine umlaufend auf die erste Fläche des Rahmenteils aufgebrachte Klebefolie auf einen ersten Teilbereich der ersten Fläche aufgetragen ist, welcher erste Teilbereich seitlich versetzt zu einem nicht mit Kleberauftrag versehen zweiten Teilbereich der ersten Fläche angeordnet ist, wobei die Schweißverbindung zwischen Deckelteil und Rahmenteil in einer Richtung senkrecht zur Leiterplatte gesehen oberhalb des zweiten Teilbereichs angeordnet ist. Dadurch wird besonders zuverlässig vermieden, dass die beim Schweißvorgang entstehenden hohen Temperaturen die Klebeverbindung zwischen Deckelteil und Leiterplatte beschädigen können, da sich unterhalb der Schweißverbindung kein Kleber befindet.

Besonders geeignet ist die Verwendung einer flexiblen Leiterplatte als Basis der Aufbau und Verbindungstechnik, da gerade bei flexiblen Leiterplatten im Stand der Technik Schwierigkeiten bei der Abdichtung zwischen der flexiblen Leiterplatte und dem aufgeklebten Deckelteil bestehen, welche durch die Erfindung vermieden werden können. Aber die Erfindung ist auch bei herkömmlichen starre Leiterplatten vorteilhaft einsetzbar.

Weiterhin vorteilhaft ist ein Verfahren zur Herstellung eines Getriebesteuermoduls mit den Merkmalen des nebengeordneten Verfahrensanspruchs.

### Kurze Beschreibung der Zeichnungen

Es zeigen
Fig. 1 einen Querschnitt durch ein Ausführungsbeispiel eines erfindungsgemäßen elektronischen Steuermoduls,
Fig. 2 ein zur Laminierung vorgesehener Stapel aus einer Trägerplatte, einer Leiterplatte und einem Rahmenteil,
Fig. 3 den Stapel aus Fig. 2 im Laminierwerkzeug,
Fig. 4 und Fig. 5 zwei Ausführungsbeispiele mit unterschiedlich aufgetragenen Klebefolien zwischen Deckelteil und Leiterplatte.

### Ausführungsformen der Erfindung

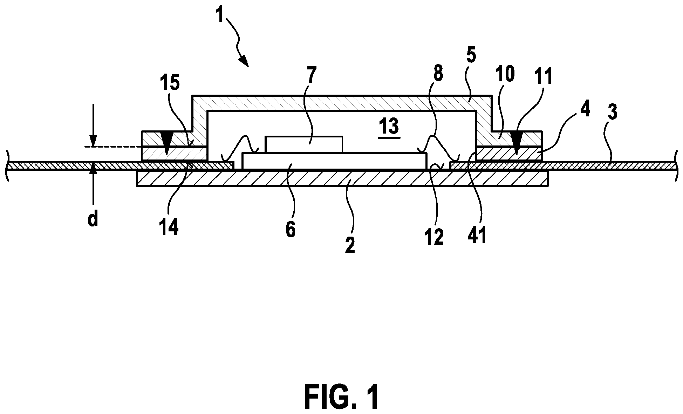

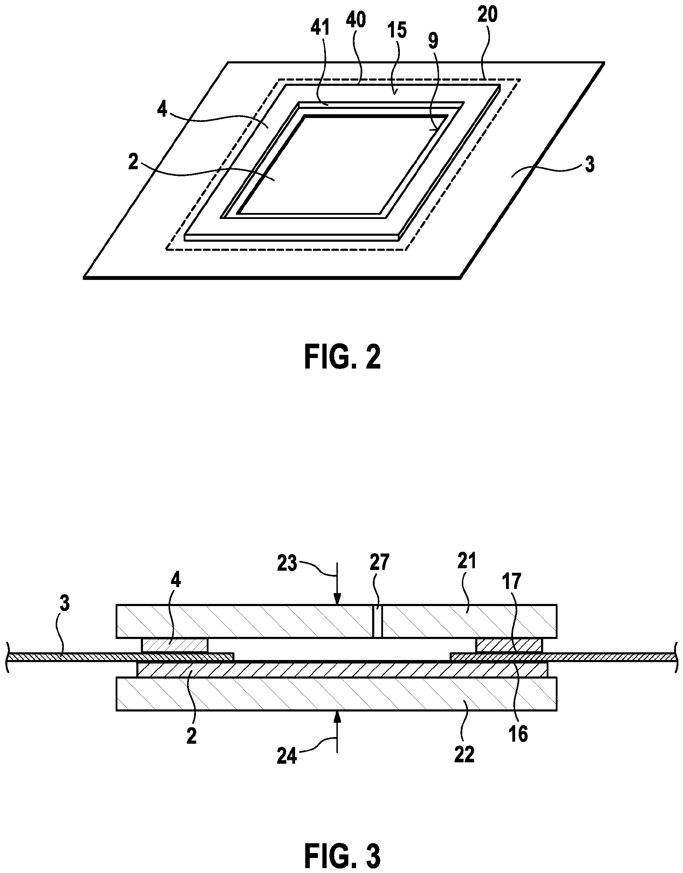

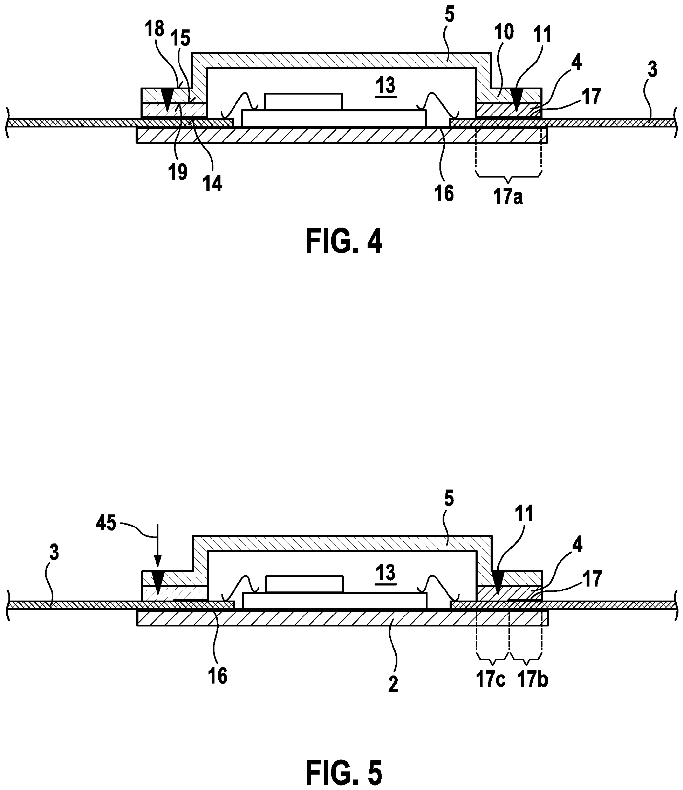

Fig. 1 zeigt schematisch einen Querschnitt durch ein erfindungsgemäßes elektronisches Steuermodul, wie es insbesondere an oder in einem Kraftfahrzeuggetriebe eingebaut werden kann. Das elektronische Steuermodul 1 ist dabei so ausgelegt, dass es dem Getriebeöl ausgesetzt werden kann. Das elektronische Steuermodul 1 in diesem Ausführungsbeispiel weist beispielsweise eine Trägerplatte 2 auf. Die Trägerplatte 2 kann beispielsweise aus Metall und vorzugsweise aus Aluminium bestehen. Auf die Trägerplatte 2 ist beispielsweise eine flexible Leiterplatte 3 aufgebracht. Hierzu kann, wie in Fig. 4 und Fig. 5 dargestellt ist, eine Klebefolie 16 auf die Oberseite der Trägerplatte 2 aufgebracht werden und die flexible Leiterplatte 3 über die Klebefolie 16 auf die Trägerplatte 2 laminiert werden. Die flexible Leiterplatte 3 weist eine Ausnehmung 9 auf, wie in Fig. 2 dargestellt ist. Durch die Ausnehmung 9 ist die mit der Klebefolie 16 beschichtete Oberseite der Trägerplatte freigelegt. Ein elektronisches Schaltungsteil 6, bei dem es sich beispielsweise um einen mit elektrischen und/oder elektronischen Bauelementen 7 bestückten Hybrid aus keramischen Material oder um eine Mikroleiterplatte oder ein anderes geeignetes Trägersubstrat für elektronische Schaltungen handeln kann, ist innerhalb der Aussparung 9 über die Klebefolie 16 mit dem Trägerteil 2 verbunden. Dabei kann es sich um die zur Aufbringung der Leiterplatte 3 verwandte Klebefolie 16 oder einen anderen Kleberauftrag handeln. Das elektronische Schaltungsteil 6 ist über elektrische Verbindungsmittel 8, welche beispielsweise als Bronddrahtverbindungen ausgeführt sein können, mit der flexiblen Leiterplatte 3 bzw. deren Leiterbahnen elektrisch kontaktiert. Die flexible Leiterplatte 3 ist vorgesehen, um die elektrische Anbindung des elektronischen Schaltungsteils 6 an außerhalb eines Gehäuseinnenraums 13 angeordnete externe Komponenten, wie beispielsweise Sensoren, Stecker oder Aktuatoren zu ermöglichen. Um das elektronische Schaltungsteil 6 vor dem Getriebeöl zu schützen, ist dieses in einem Gehäuseinnenraum 13 geschützt angeordnet.

Wie in Fig. 1 zu erkennen ist, ist ein Rahmenteil 4, das eine umlaufende Wandung 40 ausbildet und eine Innenausnehmung 41 aufweist um das elektronische Schaltungsteil 6 herum auf die Leiterplatte 3 aufgesetzt. Das Rahmenteil 4 ist als flaches, plattenförmiges, laminierbares Teil ausgebildet, das eine erste, ebene Fläche 14 und eine dazu im Abstand d von höchstens drei Millimetern angeordnete, zu der ersten Fläche 14 planparallele zweite, ebene Fläche 15 aufweist. Vorzugsweise ist das Rahmenteil 4 rechteckförmig mit einer ebenfalls reckeckförmigen Innenausnehmung 41 ausgebildet. Besonders bevorzugt ist der Abstand d zwischen der ersten Fläche 14 und der dazu planparallelen zweiten Fläche 15 kleiner als zwei Millimeter. Das Rahmenteil kann aus Kunststoff oder Metall bestehen. Die erste Fläche 14 des Rahmenteils 4 ist mittels einer umlaufend aufgebrachten Klebefolie 17 auf die Leiterplatte laminiert, wie weiter unten noch anhand der Figuren 2 und 3 erläutert wird. Auf die zweite Fläche 15 ist ein Deckelteil 5 aufgesetzt. Das Deckelteil 5 weist einen umlaufenden Kragen 10 mit einer ersten Kragenfläche 18 und einer dazu planparallelen zweiten Kragenfläche 19 (Fig. 4) auf und wird mit der ersten Kragenfläche 19 auf die zweite Fläche 15 des Rahmenteils 4 aufgesetzt. Wie in Fig. 1 dargestellt, wird das Deckelteil 5 anschießend im Bereich der Schweißverbindung 11 umlaufend mit dem Rahmenteil 4 verschweißt.

Abweichend von dem oben beschriebenen Ausführungsbeispiel kann anstelle der flexiblen Leiterplatte 3 auch eine starre Leiterplatte eingesetzt werden, um die elektrische Verbindung zwischen dem elektronischen Schaltungsteil 6 und den nicht dargestellten, außerhalb des Gehäuseinnenraums 13 angeordneten Komponenten des elektronischen Steuergerätes zu realisieren.

Weiterhin ist es auch möglich, eine starre Leiterplatte 2 zu verwenden und auf Trägerplatte 2 und die Ausnehmung 9 in der Leiterplatte 3 zu verzichten und das elektronische Schaltungsteil 6 direkt auf die Leiterplatte aufzubringen.

Wichtig ist die Anbindung des Deckelteils 5 über das Rahmenteil 4 an die Leiterplatte 3, wobei es nicht darauf ankommt, wie das Schaltungsteil 6 an dem Trägerteil 2 oder der Leiterplatte 3 festgelegt ist, obwohl die in Fig. 1 dargestellte Anbindung Vorteile aufweist in Hinblick auf die Wärmeableitung an die Trägerplatte 2.

Bei der Herstellung des in Fig. 1 dargestellten elektronischen Steuermoduls wird wie folgt verfahren: Zunächst wird, wie in Fig. 2 gezeigt, eine vorzugsweise flexible Leiterplatte 3, die eine beispielsweise rechteckförmige Aussparung 9 aufweist, auf eine Trägerplatte 2 aufgeklebt. Dabei kann die flexible Leiterplatte 3 über eine Klebefolie 16 (Fig.4) auf die Trägerplatte 2 in an sich bekannter Weise laminiert werden. Im in Fig. 2 gestrichelt gekennzeichneten Bereich 20 um die Aussparung 9 herum wird anschließend das flache, plattenförmige, laminierbare Rahmenteil 4 auf die Leiterplatte 3 aufgeklebt, so dass die umlaufende Wandung 40 des Rahmenteils 4 die Aussparung 9 umgibt und die Aussparung 9 durch die Innenausnehmung des Rahmenteils 4 frei zugänglich ist, wie dies in Fig. 2 gezeigt ist. Dabei wird so verfahren, dass eine Klebefolie 17 aus reinem Klebstoff auf die erste Fläche 14 des Rahmenteils 4 oder auf die Oberseite der flexiblen Leiterplatte 3 aufgebracht oder aufgerollt wird und anschließen das Rahmenteil 4 auf die Oberseite der flexiblen Leiterplatte 3 aufgesetzt wird.

Wie in Fig. 3 gezeigt wird der Stapel aus Trägerplatte 2, Leiterplatte 3, Klebefolie 17 und Rahmenteil 4 sodann in eine Laminierpresse eingesetzt und zwischen zwei Pressbacken 21 und 22 zusammengepresst. Die obere Pressbacke 21 weist vorzugsweise eine Entlüftungsöffnung 27 auf. Die Pfeile 23 und 24 in Fig. 3 symbolisieren die Presskraft im Laminierwerkzeug. Der aus der Presskraft resultierende Druck und gegebenenfalls zusätzlich eine Temperaturerhöhung führen dazu, dass das Rahmenteil 4 auf die Leiterplatte 3 fest laminiert wird, wobei im Bereich zwischen der ersten Fläche 14 des Rahmenteils 4 und der flexiblen Leiterplatte 3 eine blasenfreie und hermetisch dichte Klebeverbindung 17 entsteht, die ähnlich dicht ist, wie die beispielsweise ebenfalls durch Laminieren hergestellte Verbindung zwischen der flexiblen Leiterplatte 3 und der Trägerplatte 2 über die Klebefolie 16. Anschließend wird der Stapel aus dem Laminierwerkzeug herausgenommen.

Nun wird das elektronische Schaltungsteil 6 in der Aussparung 9 auf das Trägerteil 2 aufgeklebt und über elektrische Verbindungen 8 in Form von Bonddrähten mit der Leiterplatte 3 kontaktiert.

Zuletzt wird das Deckelteil 5 über dem Schaltungsteil 6 auf das Rahmenteil 4 aufgesetzt. Das Deckelteil 4 gelangt dabei mit der ebenen Kragenfläche 19 des Kragens 10 auf der gleichfalls ebenen zweiten Fläche 15 des Rahmenteils 4 zur Anlage.

Zuletzt wird das Deckelteil 5 mit dem Rahmenteil verschweißt, wobei unterschiedliche Schweißverfahren angewandt werden können. Das Rahmenteil 4 und das Deckelteil 5 können beispielsweise aus Metall bestehen. Das Schweißverfahren kann dann beispielsweise als Kondensator-Entladungsschweißen durchgeführt werden. Dabei wird, wie in Fig. 5 gezeigt, senkrecht zur Leiterplatte 3 in Richtung des Pfeils 45 in Fig. 4 geschweißt, so dass ein umlaufender Schweißbereich 11 entsteht, in dem der Kragen 10 mit dem Rahmenteil 4 verschweißt ist.

Das Rahmenteil 4 und das Deckelteil 5 können aber auch aus Kunststoff bestehen. Dann kommt als Schweißverfahren vorzugsweise Laserdurchlichtschweißen zur Anwendung. Dabei wird ein Laserstrahl senkrecht zur Leiterplatte 3 gerichtet. Das Material des Kragens 10 ist für das Laserlicht durchlässig gewählt, während das Material des Rahmenteils 4 im Bereich der ersten Fläche 15 das Laserlicht absorbiert und aufschmilzt. So entsteht eine umlaufende Schweißverbindung zwischen Rahmenteil 4 und Deckelteil 5.

Wie in Fig. 4 gezeigt, ist es möglich die Klebefolie 17 in einem Bereich 17a auf die gesamte Fläche der ersten Fläche 14 aufzutragen und die erste Fläche 14 des Rahmenteils vollflächig auf die Leiterplatte 3 aufzukleben.

Fig. 5 zeigt ein anders Ausführungsbeispiel, bei dem im Unterschied zu Fig. 4 die Klebefolie 17 nur in einem ersten Teilbereich 17b der ersten Fläche 14 aufgetragen wird. Dieser erste Teilbereich 17b ist seitlich versetzt zu einem nicht mit Klebefolie versehen zweiten Teilbereich 17c der ersten Fläche 14 angeordnet. In Fig. 5 ist der erste Teilbereich 17b beispielswiese der äußere Bereich der ersten Fläche 14 und der zweite Teilbereich 17c der innere Bereich der ersten Fläche 14, welcher näher bei dem Gehäuseinnenraum 13 liegt. Dadurch kann beim Aufschweißen des Deckelteils 5 erreicht werden, dass die umlaufende Schweißverbindung 11 in einer Richtung senkrecht zur Leiterplatte 3 gesehen über dem nicht mit Klebefolie versehenen, zweiten Teilbereich 17c angeordnet ist. Der Wärmeeintrag des Schweißvorgangs erreicht so nicht unmittelbar den Klebstoff und eine Beschädigung des Klebers im zweiten Teilbereich 17c wird dadurch vermieden. Dies ist in Fig. 4 zwar anders, jedoch wird auch hier eine ausreichende Dichtheit erzielt, da eine Wärmebeeinträchtigung des Klebefolie 17 nur im Bereich unterhalb der Schweißverbindung 11 zu erwarten ist, aber nicht in den seitlich dazu versetzten Bereichen. Dennoch ist die Vorzugsweise angestrebte Lösung diejenige, welche in Fig. 5 dargestellt ist.

Das in Fig. 2 bis 5 dargestellte Verfahren wird entsprechend durchgeführt, wenn anstelle einer flexiblen Leiterplatte eine starre Leiterplatte verwandt wird. In diesem Fall könnte dann gegebenenfalls beispielsweise noch die Trägerplatte 2 und die Klebefolie 16 entfallen und das Schaltungsteil 6 könnte beispielsweise direkt auf die Leiterplatte 2 aufgeklebt werden. In diesem Fall besteht dann der Stapel in der Laminierpresse nur aus der Leiterplatte 3 und dem über die Klebefolie 17 darauf aufgelegten Rahmenteil 4. Dies muss aber nicht notwendig so sein und der Aufbau könnte auch analog zu Fig. 1 mit einer starren Leiterplatte anstelle einer flexiblen Leiterplatte erfolgen.

## Patentansprüche

1. Elektronisches Steuermodul (1) mit einer Leiterplatte (3), einem mit der Leiterplatte elektrisch verbundenen elektronischen Schaltungsteil (6), einem Rahmenteil (4), das eine umlaufende Wandung (40) bildet und eine Innenausnehmung (41) aufweist und das um das elektronische Schaltungsteil (6) herum auf die Leiterplatte (3) aufgesetzt ist und mit der Leiterplatte (3) verklebt ist, und mit einem Deckelteil (5), das auf das Rahmenteil (4) aufgesetzt ist und mit dem Rahmenteil (4) verschweißt ist, so dass ein das Schaltungsteil (6) bergender abgedichteter Gehäuseinnenraum (13) gebildet ist, **dadurch gekennzeichnet, dass** das Rahmenteil (4) als flaches, plattenförmiges, laminierbares Teil ausgebildet ist, das eine erste Fläche (14) und eine dazu im Abstand (d) von höchstens drei Millimetern angeordnete, zu der ersten Fläche (14) planparallele zweite Fläche (15) aufweist, wobei die erste Fläche (14) des Rahmenteil (4) mittels einer umlaufend aufgebrachten Klebefolie (17) auf die Leiterplatte laminiert ist und das Deckelteil (5) einen umlaufenden Kragen (10) aufweist, der flach auf die zweite Fläche (15) des Rahmenteils (4) aufgelegt und mittels eines Schweißvorgangs umlaufend mit dem Rahmenteil (4) verschweißt ist.

2. Elektronisches Steuermodul nach Anspruch 1, **dadurch gekennzeichnet, dass** die erste Fläche (14) planparallel in einem Abstand (d) von höchstens zwei Millimetern zu der zweiten Fläche (15) angeordnet ist.

3. Elektronisches Steuermodul nach Anspruch 1 oder 2, **dadurch gekennzeichnet, dass** der Kragen (10) eine erste Kragenfläche (18) und eine dazu in einem Abstand angeordnete, zu der ersten Kragenfläche (18) planparallele zweite Kragenfläche (19) aufweist.

4. Elektronisches Steuermodul nach einem der Ansprüche 1 bis 3, **dadurch gekennzeichnet, dass** das Rahmenteil (4) und das Deckelteil (5) aus Kunststoff bestehen.

5. Elektronisches Steuermodul nach einem der Anspruch 1 bis 4, **dadurch gekennzeichnet, dass** das Rahmenteil (4) und das Deckelteil (5) aus Metall bestehen.

6. Elektronisches Steuermodul nach einem der vorstehenden Ansprüche, **dadurch gekennzeichnet, dass** die umlaufend auf die erste Fläche (14) aufgebrachte Klebefolie (17) auf einen ersten Teilbereich (17b) der ersten Fläche aufgetragen ist, welcher erste Teilbereich (17b), seitlich versetzt zu einem nicht mit Kleberauftrag versehen zweiten Teilbereich (17c) der ersten Fläche (14) angeordnet ist, wobei die Schweißverbindung (11) zwischen Deckelteil (5) und Rahmenteil (4) in einer Richtung senkrecht zur Leiterplatte (3) gesehen oberhalb des zweiten Teilbereichs (17c) angeordnet ist.

7. Elektronisches Steuermodul nach einem der vorstehenden Ansprüche, **dadurch gekennzeichnet, dass** die Leiterplatte (3) eine flexible Leiterplatte oder eine starre Leiterplatte ist.

8. Elektronisches Steuermodul nach einem der vorstehenden Ansprüche, **dadurch gekennzeichnet, dass** das Rahmenteil (4) als rechteckförmiges Plattenteil mit einer rechteckigen Aussparung (9) ausgebildet ist.

9. Elektronisches Steuermodul nach einem der vorstehenden Ansprüche, **dadurch gekennzeichnet, dass** die Leiterplatte (3) auf eine Trägerplatte (2) aufgebracht ist.

10. Verfahren zur Herstellung eines elektronischen Steuermoduls nach Anspruch 1, **gekennzeichnet durch** die Schritte:
- Bereitstellen einer Leiterplatte (3),
- Bereitstellen eines Rahmenteils (4), aufweisend eine umlaufende Wandung (40), eine Innenausnehmung (41), eine erste Fläche (14) und eine dazu im Abstand von höchstens drei Millimetern angeordnete, zu der ersten Fläche planparallele zweite Fläche (15),
- Aufbringung der ersten Fläche (14) des Rahmenteils (4) unter Zwischenlage einer Klebefolie (17) auf die Leiterplatte (3),
- Anordnen des durch Leiterplatte (3), Rahmenteil (4) und gegebenenfalls durch eine zusätzlich als Träger der Leiterplatte (3) vorgesehen Trägerplatte (2) gebildeten Stapels in einer Laminierpresse (21,22),
- Laminieren des Rahmenteils (4) auf die Leiterplatte (3) unter Druckzufuhr und vorzugsweise zusätzlich unter Temperaturzufuhr,
- Entnahme des Stapels aus der Laminierpresse (21, 22),
- Aufbringen eines elektronischen Schaltungsteils (6) auf die Leiterplatte (3) oder Aufbringen eines elektronischen Schaltungsteils (6) in einer Aussparung (9) der Leiterplatte (3) auf die Trägerplatte (2),
- Herstellen von elektrischen Verbindungen (8) zwischen dem Schaltungsteil (6) und der Leiterplatte (3),
- Aufsetzen eines einen umlaufenden Kragen (10) aufweisenden Deckelsteils (5) auf die zweite Fläche (15) des Rahmenteils (4) und
- Verschweißen des Kragens (10) mit dem Rahmenteil (4).

## Claims

1. Electronic control module (1) having a printed circuit board (3), an electronic circuit part (6) which is electrically connected to the printed circuit board, a frame part (4) which forms a circumferential wall (40) and has an inner recess (41) and is mounted on the printed circuit board (3) around the electronic circuit part (6) and is adhesively bonded to the printed circuit board (3), and having a cover part (5) which is mounted on the frame part (4) and is welded to the frame part (4), so that a sealed-off housing interior (13) which contains the circuit part (6) is formed, **characterized in that** the frame part (4) is designed as a flat, plate-like part which can be laminated and has a first surface (14) and a second surface (15) which is arranged at a distance (d) of at most three millimetres from the said first surface and is plane-parallel in relation to the first surface (14), wherein the first surface (14) of the frame part (4) is laminated onto the printed circuit board by means of a circumferentially applied adhesive film (17) and the cover part (5) has a circumferential collar (10) which is placed flat onto the second surface (15) of the frame part (4) and is circumferentially welded to the frame part (4) by means of a welding process.

2. Electronic control module according to Claim 1, **characterized in that** the first surface (14) is arranged plane-parallel at a distance (d) of at most two millimetres from the second surface (15).

3. Electronic control module according to Claim 1 or 2, **characterized in that** the collar (10) has a first collar surface (18) and a second collar surface (19) which is arranged at a distance from the said first collar surface and is plane-parallel in relation to the first collar surface (18).

4. Electronic control module according to one of Claims 1 to 3, **characterized in that** the frame part (4) and the cover part (5) are composed of plastic.

5. Electronic control module according to one of Claims 1 to 4, **characterized in that** the frame part (4) and the cover part (5) are composed of metal.

6. Electronic control module according to one of the preceding claims, **characterized in that** the adhesive film (17) which is circumferentially applied to the first surface (14) is applied to a first subregion (17b) of the first surface, which first subregion (17b) is arranged laterally offset in relation to a second subregion (17c) of the first surface (14), to which second subregion adhesive is not applied, wherein the weld connection (11) between the cover part (5) and the frame part (4) is arranged above the second subregion (17c) as seen in a direction perpendicular to the printed circuit board (3).

7. Electronic control module according to one of the preceding claims, **characterized in that** the printed circuit board (3) is a flexible printed circuit board or a rigid printed circuit board.

8. Electronic control module according to one of the preceding claims, **characterized in that** the frame part (4) is designed as a rectangular plate part with a rectangular cutout (9).

9. Electronic control module according to one of the preceding claims, **characterized in that** the printed circuit board (3) is fitted onto a carrier plate (2).

10. Method for producing an electronic control module according to Claim 1, **characterized by** the steps of:
- providing a printed circuit board (3),
- providing a frame part (4) having a circumferential wall (40), an inner recess (41), a first surface (14) and a second surface (15) which is arranged at a distance of at most three millimetres from the said first surface and is plane-parallel in relation to the first surface,
- fitting the first surface (14) of the frame part (4) onto the printed circuit board (3) with the interposition of an adhesive film (17),
- arranging the stack, which is formed by the printed circuit board (3), the frame part (4) and possibly by a carrier plate (2) which is additionally provided as a carrier of the printed circuit board (3), in a laminating press (21, 22),
- laminating the frame part (4) onto the printed circuit board (3) with the application of pressure and preferably additionally with the application of heat,
- removing the stack from the laminating press (21, 22),
- fitting an electronic circuit part (6) onto the printed circuit board (3) or fitting an electronic circuit part (6) in a cutout (9) of the printed circuit board (3) onto the carrier plate (2),
- establishing electrical connections (8) between the circuit part (6) and the printed circuit board (3),
- mounting a cover part (5) having a circumferential collar (10) onto the second surface (15) of the frame part (4), and
- welding the collar (10) to the frame part (4).

## Revendications

1. Module de commande électronique (1) comportant une carte de circuit imprimé (3), un élément de commutation électronique (6) relié électriquement à la carte de circuit imprimé, un élément de châssis (4), qui forme une paroi (40) périphérique et présente un évidement intérieur (41) et qui est posé sur la carte de circuit imprimé (3) en entourant l'élément de commutation électronique (6), et est collé à la carte de circuit imprimé (3), et un élément de couvercle (5), qui est posé sur l'élément de châssis (4) et est soudé à l'élément de châssis (4) de manière à former un espace intérieur de boîtier (13) rendu étanche abritant l'élément de commutation (6),
**caractérisé en ce que** l'élément de châssis (4) est réalisé sous la forme d'un élément plat, en frome de plaque, pouvant être stratifié, qui comporte une première face (14) et une deuxième face (15) plane parallèle disposée à une distance (d) d'au plus trois millimètres de la première face, parallèle et plane par rapport à la première face (14), dans lequel la première face (14) de l'élément de châssis (4) est stratifiée sur la carte de circuit imprimé au moyen d'un film adhésif (17) appliqué de façon circonférentielle, et l'élément de couvercle (5) comporte un rebord périphérique (10), qui est déposé à plat sur la deuxième face (15) de l'élément de châssis (4) et est soudé à l'élément de châssis (4) sur sa périphérie au moyen d'une opération de soudage.

2. Module de commande électronique selon la revendication 1, **caractérisé en ce que** la première face (14) est disposée de manière parallèle et plane à une distance (d) d'au plus deux millimètres par rapport à la deuxième face (15).

3. Module de commande électronique selon la revendication 1 ou 2, **caractérisé en ce que** le rebord (10) présente une première face de rebord (18) et une deuxième face de rebord (19) disposée à une certaine distance de la première face de rebord et de manière plane et parallèle par rapport à la première face de rebord (18).

4. Module de commande électronique selon l'une quelconque des revendications 1 à 3, **caractérisé en ce que** l'élément de châssis (4) et l'élément de couvercle (5) sont constitués de matière plastique.

5. Module de commande électronique selon l'une quelconque des revendications 1 à 4, **caractérisé en ce que** l'élément de châssis (4) et l'élément de couvercle (5) sont constitués de métal.

6. Module de commande électronique selon l'une quelconque des revendications précédentes, **caractérisé en ce que** le film adhésif (17) appliqué sur la première face (14) de manière à l'entourer est déposé sur une première zone partielle (17b) de la première face, laquelle première zone partielle (17b) est disposée de manière décalée latéralement par rapport à une deuxième zone partielle (17c) de la première face (14), qui n'est pas pourvue d'un revêtement d'adhésif, dans lequel la liaison par soudage (11) entre l'élément de couvercle (5) et l'élément de châssis (4) dans une direction perpendiculaire à la carte de circuit imprimé (3) lorsqu'on l'observe depuis le dessus de la deuxième zone partielle (17c).

7. Module de commande électronique selon l'une quelconque des revendications précédentes, **caractérisé en ce que** la carte de circuit imprimé (3) est une carte de circuit imprimé souple ou une carte de circuit imprimé rigide.

8. Module de commande électronique selon l'une quelconque des revendications précédentes, **caractérisé en ce que** l'élément de châssis (4) est réalisé sous la forme d'un élément de plaque rectangulaire comportant un évidement (9) rectangulaire.

9. Module de commande électronique selon l'une quelconque des revendications précédentes, **caractérisé en ce que** la carte de circuit imprimé (3) est appliquée sur une plaque de support (2).

10. Procédé de fabrication d'un module de commande électronique selon la revendication 1, **caractérisé par** les étapes consistant à :
- fournir une carte de circuit imprimé (3),
- fournir un élément de châssis (4), comportant une paroi (40) périphérique, un évidement intérieur (41), une première face (14) et une deuxième face (15) disposée à une distance d'au plus trois millimètres de la première face, parallèle et plane par rapport à la première face,
- appliquer la première face (14) de l'élément de châssis (4) en déposant de manière intermédiaire un film adhésif (17) sur la carte de circuit imprimé (3),
- disposer un empilement formé par la carte de circuit imprimé (3), l'élément de châssis (4), et le cas échéant, par une carte de support (2) prévue en outre en tant que support pour la carte de circuit imprimé (3), dans une presse à stratifier (21, 22),
- stratifier l'élément de châssis (4) sur la carte de circuit imprimé (3) en appliquant une pression et en appliquant en outre de préférence une température,
- retirer l'empilement de la presse à stratifier (21, 22),
- appliquer un élément de circuit électronique (6) sur la carte de circuit imprimé (3) ou appliquer un élément de circuit électronique (6) dans un évidement (9) de la carte de circuit imprimé (3) sur la carte de support (2),
- établir des liaisons électriques (8) entre l'élément de circuit (6) et la carte de circuit imprimé (3),
- poser un élément de couvercle (5) présentant un rebord périphérique (10) sur la deuxième face (15) de l'élément de châssis (4), et
- souder le rebord (10) à l'élément de châssis (4).
